## Europäisches Patentamt

## European Patent Office

## Office européen des brevets

(11) Veröffentlichungsnummer: **0 214 573**
A2

# EUROPÄISCHE PATENTANMELDUNG

(21) Anmeldenummer: **86112010.3**

(22) Anmeldetag: **29.08.86**

(51) Int.Cl.⁴: **H 01 C 17/06**
**H 05 K 1/16**

(30) Priorität: **12.09.85 DE 3532834**

(43) Veröffentlichungstag der Anmeldung:
**18.03.87 Patentblatt 87/12**

(84) Benannte Vertragsstaaten:
**BE CH DE FR GB IT LI LU NL SE**

(71) Anmelder: **SCHERING AKTIENGESELLSCHAFT Berlin
und Bergkamen
Müllerstrasse 170/178 Postfach 65 03 11
D-1000 Berlin 65(DE)**

(72) Erfinder: **Bock, Martin, Dr.
Seheimer Strasse 19
D-1000 Berlin 28(DE)**

(72) Erfinder: **Tenbrink, Detlef
Büdnerring 42
D-1000 Berlin 51(DE)**

(54) **Verfahren zur Integration von Widerständen in chemisch abgeschiedene Leiternetzwerke.**

(57) Die Erfindung betrifft ein Verfahren zur Integration hoch zuverlässiger und kleiner Dickschichtwiderstände in Leiternetzwerke, die mit chemischen oder elektrochemischen Verfahren hergestellt werden, dadurch gekennzeichnet, daß auf einen Schaltungsträger mit einem Leiternetzwerk nach dem Siebdruckverfahren Widerstandspasten gedruckt und eingebrannt beziehungsweise gehärtet werden oder daß ein Schaltungsträger nach einer haftungsverbessernden Vorbehandlung zunächst mit dem Widerstandsmuster und zugehörigen Kontaktflecken bedruckt wird und daß nach dem Einbrand beziehungsweise Aushärten der Pasten ein volladditiver Leiterbahnaufbau durch selektive chemische Metallabscheidung erfolgt.

EP 0 214 573 A2

Die Erfindung betrifft ein Verfahren zur Integration hoch zuverlässiger und kleiner Dickschichtwiderstände in Leiternetzwerke, die mit chemischen oder elektrochemischen Verfahren hergestellt werden.

In der Leiterplattentechnik sind Verfahren zum volladditiven Leiterbahnaufbau bekannt. Ebenso sind Verfahren zur haftfesten Metallisierung von Keramiksubstraten bekannt. Die Herstellung von Netzwerken mit integrierten Widerständen nach der Dickschichttechnik durch Siebdrucken, Trocknen und Einbrennen von Pasten ist ebenso bekannt.

Die Integration von passiven Bauteilen, zum Beispiel Widerständen in der Hybridmikroelektronik, führt zu sehr hoher Zuverlässigkeit durch Einsparung von Lötverbindungen und zu geringerem Platzbedarf auf dem Schaltungsträger. Die steigende Integrationsdichte bei den Halbleitern erfordert immer feinere Leiterbahnstrukturen für deren Kontaktierung, so daß abzusehen ist, daß die minimale Linienbreite der Dickschichttechnik von ca. 100 µm zu grob sein wird. Kleinere Leiterbahnbreiten können durch die bekannte Dünnschichttechnik oder durch chemische Metallisierung in Verbindung mit einer geeigneten Technik zum Leiterbahnaufbau erreicht werden. Beide Techniken bieten auch die Möglichkeit zur Widerstandsintegration, jedoch sind die Flächenwiderstände der entsprechenden Schichten so niedrig, daß höhere Widerstandswerte einen hohen Platzbedarf auf dem Substrat erfordern. Die teure Beschichtung der Schaltungsträger durch Aufdampfen oder Kathodenzerstäuben vermindert die Einsatzmöglichkeiten von Dünnfilmschaltungen.

Aufgabe der vorliegenden Erfindung ist daher ein Verfahren zur Integration hoch zuverlässiger und kleiner Dickschichtwiderstände in Leiternetzwerke, die mit chemischen oder elektrochemischen Verfahren hergestellt werden.

Postanschrift: Schering Aktiengesellschaft, Postfach 65 03 11, D-1000 Berlin 65 · Für Besucher Berlin-Wedding, Müllerstraße 170-178 · Telegramme Scheringeram Berlin

Vorstand Dr Herbert Asmis Dr Christian Bruhn Dr Heinz Hannse Horst Kramer Dr Klaus Ponle Dr Horst Witzel Vorsitzender des Aufsichtsrats Hans-Jürgen Hamann Sitz der Gesellschaft Berlin und Bergkamen Handelsregister AG Charlottenburg 93 HRB 283 und AG Kamen HRB 0061 Berliner Commerzbank AG, Berlin Konto-Nr 108720600 Bankleitzahl 100 400 00 Berliner Handels- und Frankfurter Bank, Berlin Konto-Nr 70045224 Bankleitzahl 100 202 00 Deutsche Bank Berlin AG, Konto-Nr 2415008 Bankleitzahl 100 700 00 Postscheckamt Berlin West Konto-Nr 1175-101 Bankleitzahl 100 100 10

Diese Aufgabe wird erfindungsgemäß durch ein Verfahren der eingangs bezeichneten Art gelöst, das dadurch gekennzeichnet ist, daß auf einen Schaltungsträger mit einem Leiternetzwerk, nach dem Siebdruckverfahren Widerstandspasten gedruckt und eingebrannt beziehungsweise gehärtet werden oder daß ein Schaltungsträger nach einer haftungsverbessernden Vorbehandlung zunächst mit dem Widerstandsmuster und zugehörigen Konta-ktflecken bedruckt wird und daß nach dem Einbrand beziehungsweise Aushärten der Pasten ein volladditiver Leiterbahnaufbau durch selektive chemische Metallabscheidung , das nach modifizierten Verfahren der LP-Technik hergestellt worden ist, erfolgt.

Besondere Ausführungsformen des Verfahrens nach der ersten Variante bestehen darin,

a) daß auf einem Schaltungsträger, vorzugsweise einem Keramiksubstrat nach bekannten subtraktiven, semiadditiven oder additiven Techniken ein Leiterbild erzeugt wird,

b) daß das Leiterbild mit einer Vergütungsschicht versehen wird, vorzugsweise aus Nickel und Gold,

c) daß die Widerstandsstruktur durch Siebdrucken, Trocknen und Einbrennen beziehungsweise Härten geeigneter Pasten erzeugt wird.

Besondere Ausführungsformen des Verfahrens nach der zweiten Variante bestehen darin,

d) daß der Schaltungsträger zunächst für eine haftfeste chemische Metallisierung vorbehandelt wird,

-5-

e) daß die Widerstandsstruktur durch Siebdrucken, Trocknen und Einbrennen beziehungsweise Härten geeigneter Pasten erzeugt wird,

f) daß über die Widerstandsstruktur durch Siebdrucken, Trocknen und Einbrennen beziehungsweise Härten geeigneter Leitpasten Kontaktflecken gelegt werden, falls das Widerstandsmaterial nicht haftfest metallisierbar ist,

g) daß der Schaltungsträger in üblicher Weise, zum Beispiel mit einer palladiumhaltigen Lösung für die chemische Metallisierung aktiviert und anschließend getrocknet wird,

h) daß der Schaltungsträger mit einem Resist versehen wird, wobei die Kontaktflecken der Widerstände und die aufzubauende Leiterbahnstruktur freigelegt werden,

i) daß der mit Resist beschichtete Schaltungsträger an den freigelegten Flächen mit einem geeigneten chemisch-reduktiv arbeitenden Bad vorzugsweise mit Kupfer oder Nickel metallisiert wird,

j) daß der Resist vom Schaltungsträger entfernt wird, sofern es sich nicht um einen sogenannten Permanent-Resist handelt, der die Widerstandsstruktur vor Umwelteinflüssen schützt.

Das erfindungsgemäße Verfahren hat gegenüber den bekannten Verfahren der Dünn- und Dickschichttechnik den Vorteil, kostengünstig sehr feine Leiterbahnstrukturen hoher Leitfähigkeit mit hoch zuverlässigen kleinen integrierten Schichtwiderständen zu kombinieren und dadurch eine wei-

-6-

tere Steigerung der Funktionsdichte einer Schaltung zu ermöglichen.

Das erfindungsgemäße Verfahren eignet sich in hervorragender Weise zur Herstellung von Hybridschaltungen auf keramischen Substraten, kann aber auch zur Herstellung von Schaltungen auf anderen anorganischen oder organischen Isolierstoffen angewendet werden.

Die Durchführung des erfindungsgemäßen Verfahrens wird in den folgenden Beispielen beschrieben:

Postanschrift: Schering Aktiengesellschaft, Postfach 65 03 11, D-1000 Berlin 65 · Für Besucher Berlin-Wedding, Müllerstraße 170-178 · Telegramme Scheringconcern Berlin
Vorstand: Dr Herbert Asmis Dr Christian Brunn Dr Heinz Hannte Horst Krams Dr Klaus Ponte, Dr Horst Witzel Vorsitzender des Aufsichtsrats Hans-Jürgen Hamm
Sitz der Gesellschaft Berlin und Bergkamen Handelsregister AG Charlottenburg 93 HRB 283 und AG Kamen HRB 0061 Berliner Commerzbank AG. Berlin Konto-
Nr Bankleitzahl 100 400 00 Berliner Handels- und Frankfurter Bank, Berlin Konto-Nr 70045224 Bankleitzahl 100 202 00 Deutsche Bank Berlin AG Konto-
Nr Bankleitzahl 100 700 00 Postscheckamt Berlin West, Konto-Nr 11 75-101 Bankleitzahl 100 100 10

BEISPIEL 1:

Eine kleberbeschichtete Platte aus glasfaserverstärktem Epoxidharz wird in der üblichen Weise nach dem Semiadditiv-Verfahren mit einem Leiterbild versehen, mit Polymer-Widerstandspasten bedruckt, die gedruckten Pasten getrocknet und gehärtet.

Postanschrift: Schering Aktiengesellschaft, Postfach 65 03 11, D-1000 Berlin 65 · Für Besucher: Berlin-Wedding, Müllerstraße 170-178 · Telegramme: Scheringchemie Berlin

Vorstand: Dr. Herbert Asmis, Dr. Christian Bruhn, Dr. Heinz Hannse, Horst Kramp, Dr. Klaus Pohle, Dr. Horst Witzel · Vorsitzender des Aufsichtsrats: Hans-Jürgen Hamann
Sitz der Gesellschaft: Berlin und Bergkamen · Handelsregister: AG Charlottenburg 93 HRB 283 und AG Kamen HRB 308 · Berliner Commerzbank AG, Berlin, Konto-Nr.
108700530 Bankleitzahl 100 400 00 · Berliner Handels- und Frankfurter Bank, Berlin, Konto-Nr. 70045224 Bankleitzahl 100 202 00 · Deutsche Bank Berlin AG, Konto-Nr.
2416008 Bankleitzahl 100 700 00 · Postscheckamt Berlin West Konto-Nr. 1175-101 Bankleitzahl 100 100 10

BEISPIEL 2:

Auf einer chemisch-galvanisch mit der Schichtfolge Kupfer-Nickel-Gold metallisierten Aluminiumoxidkeramikplatte werden Niedertemperatur-Widerstandspasten gedruckt, nach Herstellerangaben getrocknet und in Luft bei 625 $^\circ$ C Maximaltemperatur eingebrannt.

Postanschrift: Schering Aktiengesellschaft, Postfach 65 03 11, D-1000 Berlin 65 · Für Besucher: Berlin-Wedding, Müllerstraße 170-178   Telegramme: Scheringorama Berlin
Vorstand: Dr. Herbert Asmis, Dr. Christian Bruhn, Dr. Heinz Hannse, Horst Kramp, Dr. Klaus Pohle, Dr. Horst Witzel   Vorsitzender des Aufsichtsrats: Hans-Jürgen Hamann
Sitz der Gesellschaft: Berlin und Bergkamen   Handelsregister: AG Charlottenburg 93 HRB 283 und AG Kamen HRB 0061   Berliner Commerzbank AG, Berlin Konto-Nr.
02710900   Bankleitzahl 100 40 000   Berliner Handels- und Frankfurter Bank Berlin Konto-Nr. 70045224 Bankleitzahl 100 202 00   Deutsche Bank Berlin AG Konto-Nr.
24/5098 Bankleitzahl 100 700 10   Postscheckamt Berlin West Konto-Nr. 1175-101 Bankleitzahl 100 100 10

BEISPIEL 3:

Auf ein Keramiksubstrat mit einem im Additiv-Verfahren aufgebrachten Kupfer-Leiternetzwerk werden* Widerstandspasten gedruckt, bei 125 $^{\circ}$ C getrocknet und bei einer Maximaltemperatur von 925 $^{\circ}$ C in Stickstoff eingebrannt.

* in Stickstoff einbrennbare

Postanschrift: Schering Aktiengesellschaft, Postfach 65 03 11, D-1000 Berlin 65 · Für Besucher Berlin-Wedding, Müllerstraße 170-178 · Telegramme: Scheringchem Berlin

Vorstand: Dr. Herbert Asmis, Dr. Christian Bruhn, Dr. Heinz Hannse, Horst Kramp, Dr. Klaus Pohle, Dr. Horst Witzel · Vorsitzender des Aufsichtsrats: Hans-Jürgen Hartmann
Sitz der Gesellschaft: Berlin und Bergkamen · Handelsregister AG Charlottenburg 93 HRB 283 und AG Kamen HRB 005 · Berliner Commerzbank AG Berlin, Konto-Nr.
05700600 Bankleitzahl 100 400 00 · Berliner Handels- und Frankfurter Bank Berlin, Konto-Nr. 70045224 Bankleitzahl 100 202 00 · Deutsche Bank Berlin AG, Konto-Nr.
2416 08 Bankleitzahl 100 700 00 · Postscheckamt Berlin West Konto-Nr. 1175-101 Bankleitzahl 100 100 10

0214573

BEISPIEL 4:

Ein Schaltungsträger aus Aluminiumoxidkeramik wird durch ein geeignetes Ätzmittel chemisch aufgerauht, um eine haftfeste chemische Metallisierung zu ermöglichen, mit einer Widerstandspaste bedruckt, nach Herstellerangaben getrocknet, eingebrannt, die Kontaktflecken mit einer Leitpaste gedruckt, getrocknet, eingebrannt und in einer palladiumhaltigen Lösung ganzflächig für die chemische Metallisierung aktiviert. Anschließend wird er mit einem alkalibeständigen Photoresist beschichtet. Dieser wird so belichtet und entwickelt, daß die chemisch zu verkupfernden Flächen freigelegt werden. Die Leiterbahnen und Kontaktflecken werden mit chemisch abgeschiedenem Kupfer 10 µm dick beschichtet.

Postanschrift: Schering Aktiengesellschaft, Postfach 65 03 11, D-1000 Berlin 65 · Für Besucher Berlin-Wedding, Müllerstraße 170-178 · Telegramme: Scheringchemie Berlin

Vorstand: Dr. Herbert Asmis, Dr. Christian Bruhn, Dr. Heinz Hünnefe, Horst Kramp, Dr. Klaus Pohle, Dr. Horst Witzel · Vorsitzender des Aufsichtsrats: Hans-Jürgen Humann · Sitz der Gesellschaft Berlin und Bergkamen · Handelsregister AG Charlottenburg 93 HRB 283 und AG Kamen HRB 0061 · Berliner Commerzbank AG, Berlin, Konto-Nr. 108700000 Bankleitzahl 100 400 00 · Berliner Handels- und Frankfurter Bank Berlin, Konto-Nr. 700 45224 Bankleitzahl 100 202 00 · Deutsche Bank Berlin AG, Konto-Nr. 24 56003 Bankleitzahl 100 700 00 · Postscheckamt Berlin West Konto-Nr. 175-101, Bankleitzahl 100 100 10

BEISPIEL 5:

Ein Schaltungsträger wird wie in Beispiel 4 vorbehandelt und mit Widerständen und zugehörigen Kontaktflecken versehen. Anschließend wird der Schaltungsträger mit einem Photoresist beschichtet, der so belichtet und entwickelt wird, daß die chemisch zu verkupfernden Flächen - Leiterbahnen und Kontaktflecken - freigelegt werden. Diese werden mit einer palladiumhaltigen Lösung aktiviert und nach Strippen des Resists 10 µm dick chemisch verkupfert.

Postanschrift: Schering Aktiengesellschaft, Postfach 65 03 11, D-1000 Berlin 65 · Für Besucher Berlin-Wedding, Müllerstraße 170-178 · Telegramme Scheringchemie Berlin

Vorstand: Dr. Herbert Asmis, Dr. Christian Bruhn, Dr. Heinz Hannse, Horst Kramp, Dr. Klaus Pohle, Dr. Horst Witzel · Vorsitzender des Aufsichtsrats: Hans-Jürgen Hamann
Sitz der Gesellschaft: Berlin und Bergkamen · Handelsregister: AG Charlottenburg 93 HRB 283 und AG Kamen HRB 0061 · Berliner Commerzbank AG Berlin Konto Nr.
105750600 Bankleitzahl 100 400 00 · Berliner Handels- und Frankfurter Bank Berlin Konto Nr. 70045224 Bankleitzahl 100 202 00 · Deutsche Bank Berlin AG Konto Nr.
2415008 Bankleitzahl 100 700 00 · Postscheckamt Berlin West, Konto-Nr. 1175-101 Bankleitzahl 100 100 10

BEISPIEL 6:

Ein keramisches Substrat wird wie in Beispiel 4 vorbehandelt und anschließend mit Widerstandspasten bedruckt. Nach dem Einbrand der Widerstände wird der Schaltungsträger wie in Beispiel 4 ganzflächig mit einem polymeren Netzmittel behandelt und für die chemische Metallabscheidung aktiviert. Im nächsten Schritt wird das Substrat mit einem Photoresist beschichtet, der so belichtet und entwickelt wird, daß die zu metallisierenden Leiterbahnen und Kontaktflächen des Widerstandsmaterials freigelegt werden. Die freientwickelten Flächen werden chemisch vernickelt und in einem chemischen Goldbad vergütet.

Postanschrift: Schering Aktiengesellschaft, Postfach 65 03 11, D-1000 Berlin 65 · Für Besucher Berlin-Wedding, Müllerstraße 170-178 · Telegramme Scheringchemie Berlin · Vorstand: Dr Herbert Asmis, Dr Christian Bruhn, Dr Heinz Hannse, Horst Kramp, Dr Klaus Pohle, Dr Horst Witzel · Vorsitzender des Aufsichtsrats: Hans-Jürgen Harm · Sitz der Gesellschaft: Berlin und Bergkamen · Handelsregister: AG Charlottenburg 93 HRB 283 und AG Kamen HRB 0061 · Berliner Commerzbank AG, Berlin Konto-103700600 Bankleitzahl 100 400 00 · Berliner Handels- und Frankfurter Bank, Berlin Konto-Nr 7004522 1 Bankleitzahl 100 202 00 · Deutsche Bank Berlin AG, Konto-2415008 Bankleitzahl 100 700 00 · Postscheckamt Berlin West, Konto-Nr 1175-101, Bankleitzahl 100 100 10

BEISPIEL 7:

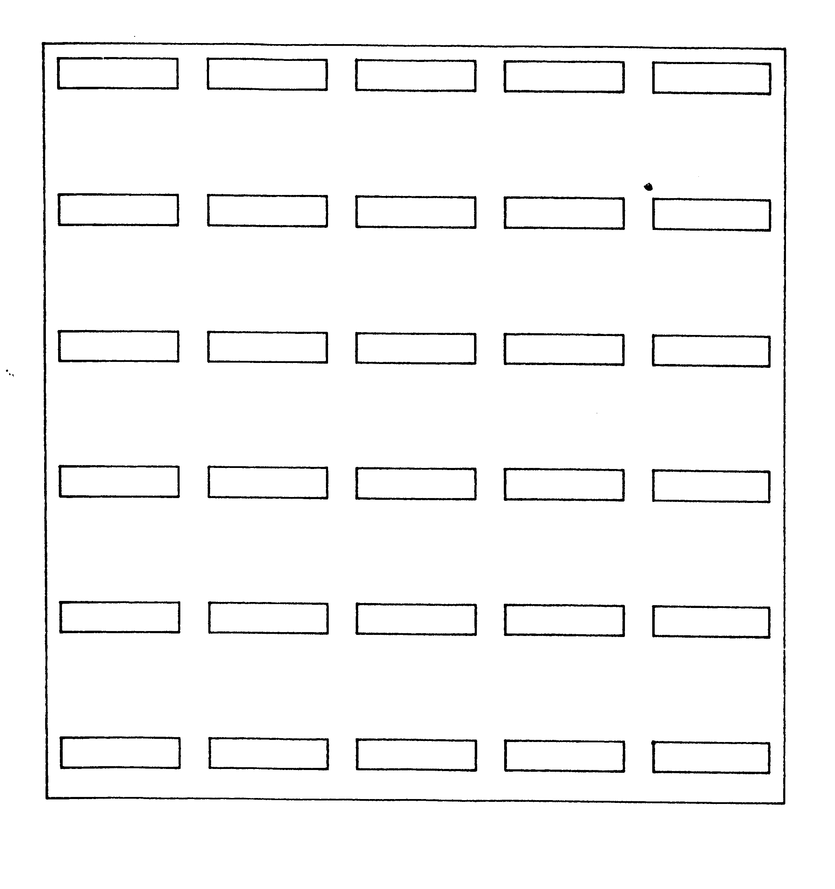

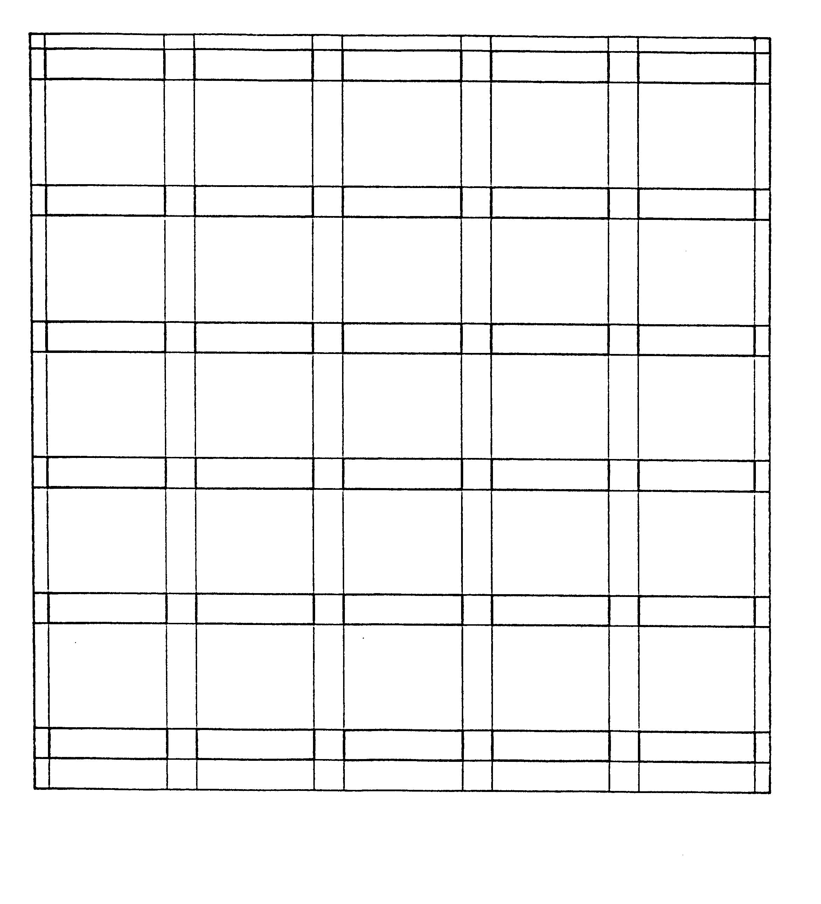

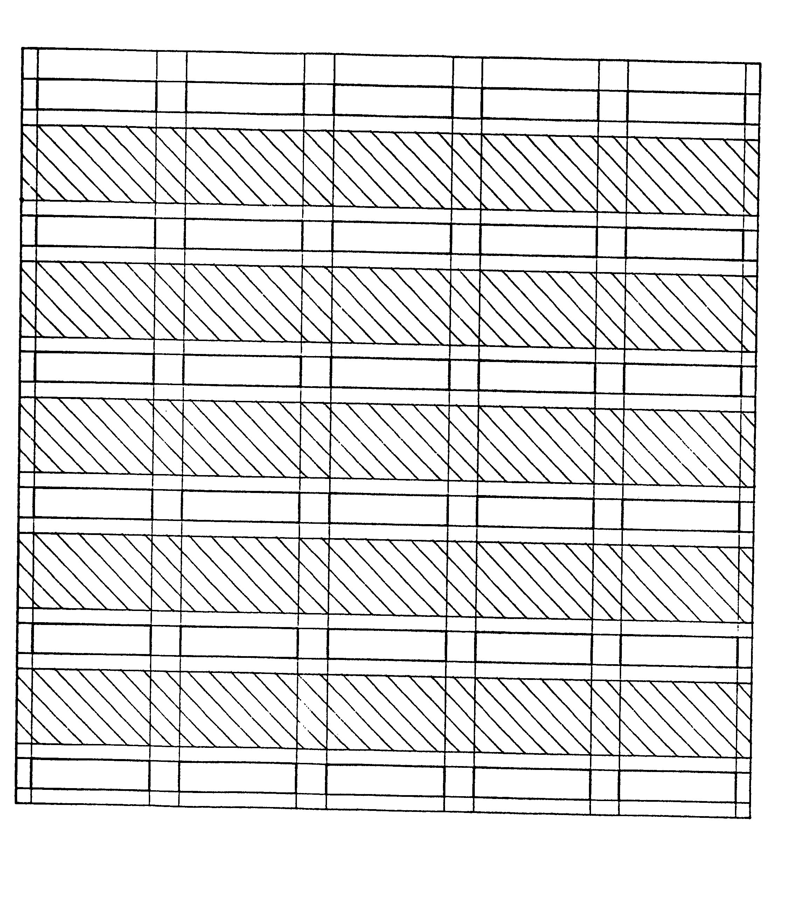

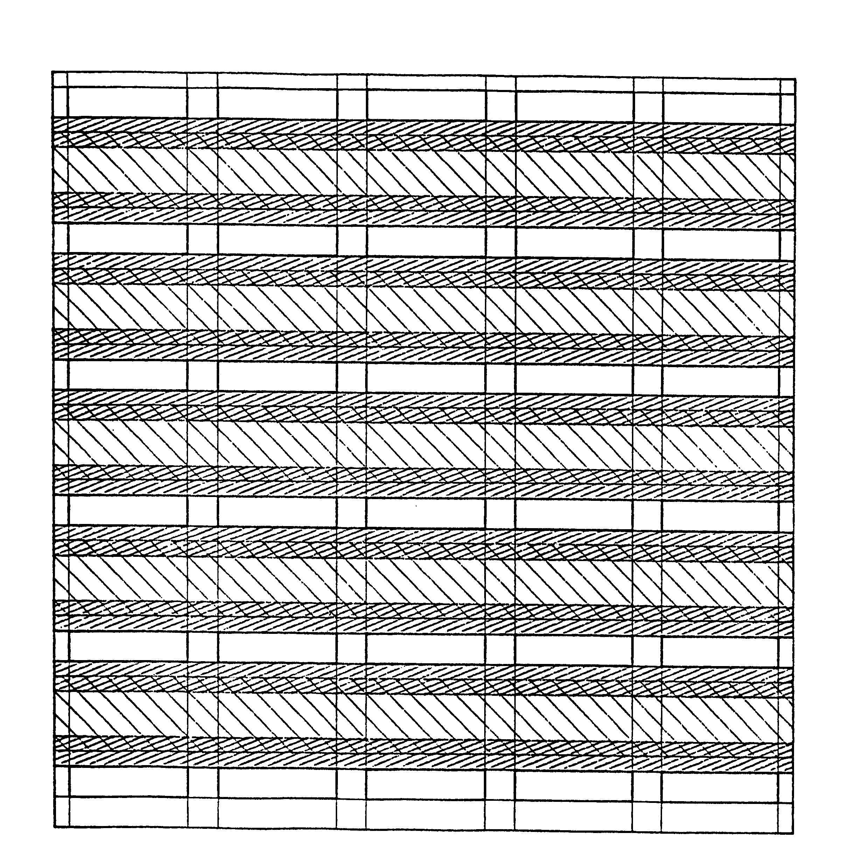

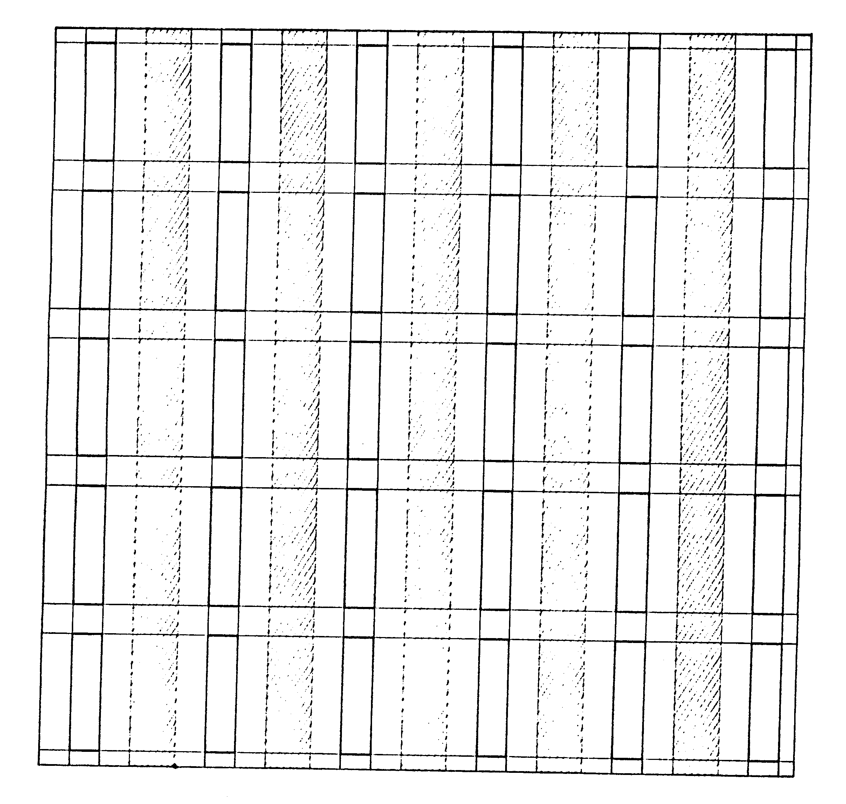

Ein Keramiksubstrat nach Abb. 1 mit Reihen gestanzter Löcher wird mit dem Laser kreuzweise geritzt (Abb.2) und anschließend in einer Alkalihydroxidschmelze aufgerauht. Eine Widerstandspaste wird wie in Abb. 3 ersichtlich gedruckt, getrocknet und eingebrannt. Eine Silber-Palladium-Leitpaste wird streifenweise (Abb. 4) gedruckt, getrocknet und eingebrannt. Anschließend wird das Substrat in einem für die chemische Metallisierung üblichen Aktivator aktiviert und über die freiliegende Widerstandsschicht und auf der Rückseite des Substrats entsprechend Abb. 5 eine Kunstharzpaste gedruckt. Nach Härtung der Abdeckpaste wird das Substrat chemisch vernickelt. Nach Brechen längs der Ritzlinien erhält man Chipwiderstände.

-14-

Postanschrift: Schering Aktiengesellschaft, Postfach 65 03 11, D-1000 Berlin 65 · Für Besucher: Berlin-Wedding, Müllerstraße 170-178  Telegramme. Scheringchemie Berl

Vorstand. Dr. Herbert Asmis, Dr. Christian Bruhn, Dr. Heinz Hannse, Horst Kramp, Dr. Klaus Ponle, Dr. Horst Witzel  Vorsitzender des Aufsichtsrats: Hans-Jürgen Hamar
Sitz der Gesellschaft: Berlin und Bergkamen  Handelsregister: AG Charlottenburg 93 HRB 283 und AG Kamen HRB 0061  Berliner Commerzbank AG, Berlin  Konto
108700600, Bankleitzahl 100 400 00  Berliner Handels- und Frankfurter Bank, Berlin, Konto-Nr. 70045224  Bankleitzahl 100 202 00  Deutsche Bank Berlin AG, Konto
2415008, Bankleitzahl 100 700 00  Postscheckamt Berlin West, Konto-Nr. 11 75-101, Bankleitzahl 100 100 10

# PATENTANSPRÜCHE

1. Verfahren zur Integration hoch zuverlässiger und kleiner Dickschichtwiderstände in Leiternetzwerke, die mit chemischen oder elektrochemischen Verfahren hergestellt werden, dadurch gekennzeichnet, daß auf einen Schaltungsträger mit einem Leiternetzwerk nach dem Siebdruckverfahren Widerstandspasten gedruckt und eingebrannt beziehungsweise gehärtet werden oder daß ein Schaltungsträger nach einer haftungsverbessernden Vorbehandlung zunächst mit dem Widerstandsmuster und zugehörigen Kontaktflecken bedruckt wird und daß nach dem Einbrand beziehungsweise Aushärten der Pasten ein volladditiver Leiterbahnaufbau durch selektive chemische Metallabscheidung erfolgt.

2. Verfahren gemäß Anspruch 1, dadurch gekennzeichnet, daß auf einem Schaltungsträger, vorzugsweise einem Keramiksubstrat nach bekannten subtraktiven, semiadditiven oder additiven Techniken ein Leiterbild erzeugt wird.

3. Verfahren gemäß Anspruch 1, dadurch gekennzeichnet, daß das Leiterbild mit einer Vergütungsschicht versehen wird, vorzugsweise aus Nickel und Gold.

4. Verfahren gemäß Anspruch 1, dadurch gekennzeichnet, daß die Widerstandsstruktur durch Siebdrucken, Trocknen und Einbrennen beziehungsweise Härten geeigneter Pasten erzeugt wird.

5. Verfahren gemäß Anspruch 1, dadurch gekennzeichnet, daß der Schaltungsträger zunächst für eine haftfeste chemische Metallisierung vorbehandelt wird.

-2-

Postanschrift: Schering Aktiengesellschaft, Postfach 65 03 11, D-1000 Berlin 65 · Für Besucher Berlin-Wedding, Müllerstraße 170-178 · Telegramme Scheringchemie Be Vorstand: Dr. Herbert Asmis Dr. Christian Bruhn Dr. Heinz Hannse Horst Krama Dr. Klaus Pohle, Dr. Horst Witzel Vorsitzender des Aufsichtsrats Hans-Jürgen Ham Sitz der Gesellschaft Berlin und Bergkamen Handelsregister AG Charlottenburg 03 HRB 283 und AG Kamen HRB 2061 Berliner Commerzbank AG, Berlin, Konto 0670000 Bankleitzahl 100 400 00 Berliner Handels- und Frankfurter Bank Berlin Konto-Nr 7004523 Bankleitzahl 100 202 00 Deutsche Bank Berlin AG, Konto 24 0008 Bankleitzahl 100 700 00 Postscheckamt Berlin West Konto-Nr 11 75-101 Bankleitzahl 100 100 10

6. Verfahren gemäß Anspruch 1, dadurch gekennzeichnet, daß die Widerstandsstruktur durch Siebdrucken, Trocknen und Einbrennen beziehungsweise Härten geeigneter Pasten erzeugt wird.

7. Verfahren gemäß Anspruch 1, dadurch gekennzeichnet, daß über die Widerstandsstruktur durch Siebdrucken, Trocknen und Einbrennen beziehungsweise Härten geeigneter Leitpasten Kontaktflecken gelegt werden, falls das Widerstandsmaterial nicht haftfest metallisierbar ist.

8. Verfahren gemäß Anspruch 1, dadurch gekennzeichnet, daß der Schaltungsträger in üblicher Weise, zum Beispiel mit einer palladiumhaltigen Lösung für die chemische Metallisierung aktiviert und anschließend getrocknet wird.

9. Verfahren gemäß Anspruch 1, dadurch gekennzeichnet, daß der Schaltungsträger mit einem Resist versehen wird, wobei die Kontaktflecken der Widerstände und die aufzubauende Leiterbahnstruktur freigelegt werden.

10. Verfahren gemäß Anspruch 1, dadurch gekennzeichnet, daß der mit Resist beschichtete Schaltungsträger an den freigelegten Flächen mit einem geeigneten chemisch-reduktiv arbeitenden Bad vorzugsweise mit Kupfer oder Nickel metallisiert wird.

11. Verfahren gemäß Anspruch 1, dadurch gekennzeichnet, daß der Resist vom Schaltungsträger entfernt wird, sofern es sich nicht um einen sogenannten Permanent-Resist handelt, der die Widerstandsstruktur vor Umwelteinflüssen schützt.

12. Leiterplatten hergestellt nach den Verfahren gemäß Ansprüchen 1 bis 11.

Postanschrift: Schering Aktiengesellschaft, Postfach 65 03 11, D-1000 Berlin 65 · Für Besucher: Berlin-Wedding, Müllerstraße 170-178 Telegramme: Scheringpharma Ber
Vorstand: Dr Herbert Asmis, Dr Christian Bruhn, Dr Heinz Harinse, Horst Kramp, Dr Klaus Pohle, Dr Horst Witzel Vorsitzender des Aufsichtsrats: Hans-Jürgen Harna
Sitz der Gesellschaft Berlin und Bergkamen Handelsregister: AG Charlottenburg 93 HRB 283 und AG Kamen HRB 0061 Berliner Commerzbank AG Berlin Konto-
108700600 Bankleitzahl 100 400 00 Berliner Handels- und Frankfurter Bank Berlin Konto-Nr 70045224 Bankleitzahl 100 202 00 Deutsche Bank Berlin AG Konto-
2415008 Bankleitzahl 100 700 00 Postscheckamt Berlin West Konto-Nr 1175-101 Bankleitzahl 100 100 10

0.214573